# EUROPEAN PATENT APPLICATION

(11) **EP 4 145 547 A1**
(43) Date of publication of application: **08.03.2023**
(21) Application number: 21461582.5
(22) Date of filing: 03.09.2021
(51) Int. Cl.: H01L 51/42, H01L 51/44

(54) **PEROVSKITE SOLAR CELL**

(71) Applicant: Saule S.A., 02-676 Warszawa (PL)
(72) Inventor: Wojciechowski, Konrad, 52-016 Wroclaw (PL); Babu, Vivek, 54-129 Wroclaw (PL); Fuentes Pineda, Rosinda, 53-326 Wroclaw (PL); Ivanovska, Tanja, 50-502 Wroclaw (PL)
(74) Representative: Kancelaria Eupatent.pl Sp. z.o.o

(57) **Abstract**

A perovskite solar cell having a stack of layers, wherein the layers are arranged in the following order: a front electrode layer 15, a photo-active layer 13 comprising a perovskite material, and a back electrode layer 11 comprising a porous carbon material having a plurality of open-through pores 111. The solar cell further comprises a charge transport material 12 that fills at least some of the plurality of open-through pores 111 of the porous carbon material of the back electrode layer 11.

## Description

### TECHNICAL FIELD

The present disclosure relates to a perovskite solar cell (PSC) for photovoltaic (PV) applications, including indoor and outdoor solar structures, glass-based solar cell modules, flexible substrate-based solar cell modules, etc.

### BACKGROUND

Solar devices with perovskite solar cells (PSCs) of planar heterojunction arrangement, in the n-i-p or p-i-n configuration, are commercially attractive. In these devices, individual materials are applied sequentially in the form of thin layers (films), including two electrodes, called also contacts, a transparent or translucent front electrode (TFC), and typically an opaque or semi-transparent back electrode. Typically, the back electrodes are made of metal, e.g. gold or silver. The PSCs also comprise a stack of layers, including a photo-active layer of perovskite, disposed between the two electrodes. The perovskite constitutes photo-active material, which may be sandwiched with two charge transport layers, the hole transport layer (HTL) and the electron transport layer (ETL). However, due to the polycrystalline nature of the perovskite material, the crystallographic quality of the perovskite layer (perovskite grain orientation distribution, and grain size distribution) affects the optoelectronic properties of the photo-active film, and in turn the photovoltaic parameters of the entire device.

One of the known approaches aiming at improvement in performance of heterojunction (HJ) PSCs devices lies with providing a bulk heterojunction (BHJ) employing (instead of planar contact) an intimate contact (in a bulk) between donor and acceptor molecules in a blended film that facilitates charge generation and formation of charge-transport pathways allowing for efficient charges extraction from the bulk film to desired metal electrodes. In the bulk heterojunction, the donor and acceptor molecules, at their interface, form thereby donor-acceptor charge-transport complexes (CT). Thereby, the structures of integrated perovskite/BHJ based solar cells typically can show enhanced light harvesting.

From the patent literature, there are known architectures that employ integrated perovskite/BHJ solar cells for PV applications.

Chinese patent publication CN106654020 presents a perovskite solar cell architecture with bulk heterojunction (BHJ) where the perovskite material is arranged as an electron donor. This bulk heterojunction is arranged on the surface of the perovskite thin film, employing acceptor component of the BHJ selected from crystalline TiO₂, crystalline SnO₂, crystalline ZnO, fullerene, fullerene derivative, perylene, naphthalimide, based on thiophene fused ring organic macromolecule material, graphene, carbon black, graphite, crystalline Fe₂O₃, crystalline ZnSnO₃, crystalline CdS, or CdSe nanocrystal. The production method of the perovskite solar cell consists in coating a substrate (e.g. FTO glass) with a perovskite precursor solution and perovskite/electron acceptor material dispersion, forming a heterojunction precursor film, and conducting crystallization to obtain bulk heterojunction.

Chinese patent application CN108574050 describes the method for preparation of perovskite solar architecture involving perovskite/MoS₂ BHJ. The method comprises preparation of PEDOT:PPS hole transporting layer on the ITO glass; next, a MoS₂ buffer layer is formed thereon; subsequently, the perovskite-MoS₂ heterojunction is prepared on the buffer layer. Obtained this way, the perovskite-MoS₂ heterojunction layer is coated with the electron transport layer of PBCM. PBCM is coated with a hole-blocking layer of Bphen, and finally with Ag electrode layer.

Among the known structures of perovskite solar cells, those of carbon top (back) electrodes are of increased interest. Carbon constitutes considerably low-cost electrode material (in comparison with silver and gold electrodes) exhibiting an efficient collection of charges, e.g. holes. Carbon electrodes can be prepared from carbon paste which typically comprises graphite flakes and carbon black powder as carbon donating ingredients. Furthermore, carbon is considered a stable and anticorrosive material, and carbon PSCs (C-PSCs) show good long-term stability in an ambient environment.

However, one of the drawbacks associated with using carbon as the back (top) electrode layer in the n-i-p architecture PSCs lies in poor contact at the perovskite/carbon interface. This leads to ineffective selectivity of charges and unexpected electron-hole recombination occurring at the carbon/perovskite interface.

For that reason, the C-PSCs devices may suffer from low device efficiency. To address this drawback, a charge transport layer (HTL), e.g. copper phthalocyanine (CuPc), and spiro-OMeTAD, CuSCN or the other materials such as polymers, e.g., P3HT, PEDOT:PSS, PTAA, poly-TPD, are provided between the carbon electrode and perovskite layer, resulting in reduced charge recombination, and thereby enhanced performance of C-PSCs device.

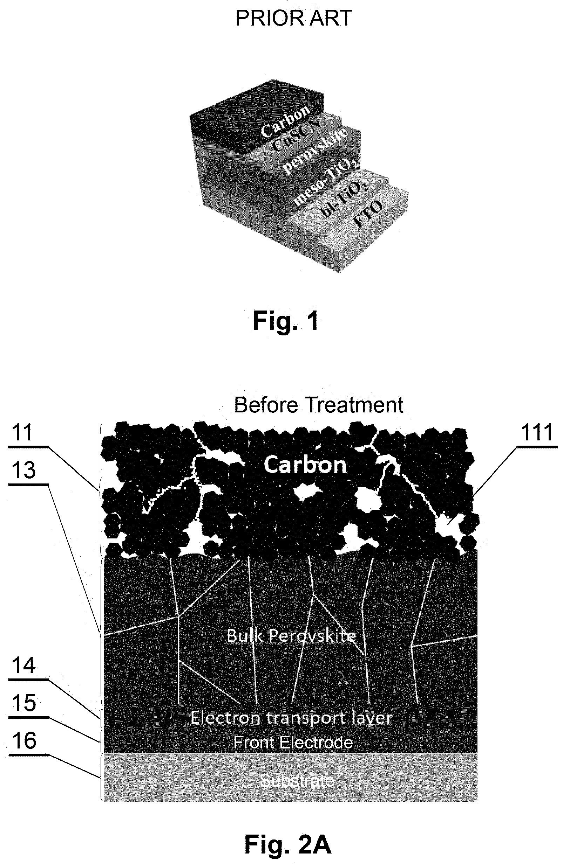

The scientific publication of Xin Wu et all, "Efficient and stable carbon-based perovskite solar cells enabled by the inorganic interface of CuSCN and carbon nanotubes", J. Mater. Chem. A, 2019, 7, 12236-12243 (DOI: 10.1039/c9ta02014d) describes HTM-free and CuSCN-based C-PSCs, shown in Fig. 1. The described solar cell comprises the following architecture: FTO/compact TiO₂/mesoporous TiO₂/perovskite/CuSCN/carbon electrode. In this configuration, CuSCN facilitates hole transport at the interface, enhances charge extraction efficiency, and contributes to a reduction of carrier recombination, at the perovskite/carbon contact. The layer of CuSCN is prepared directly on a substrate of FTO/TiO₂/perovskite, by spin-coating process, and carrying out substantially fast crystallization process - to obtain dense, smooth and continuous CuSCN film, without cracks and pinholes. The carbon electrode is prepared on the existing CuSCN layer.

In C-PCSs, the character of the perovskite/carbon interface affects the photovoltaic performance and efficiency of the cell. The performance loss originating from said character largely depends on the energy level alignment at the interface and the continuity of the mechanical contact between perovskite grains and large graphite particles typically comprised in the layer of carbon back contact electrode.

In these architectures, the application of p-type charge transport materials (i.e. p-type semiconductors), such as spiro-OMeTAD, PTAA polymer, P3HT polymer etc., can involve inconveniences, including substantially high costs of p-type materials limited thermal resistance (difficult to anneal carbon electrode deposited on such p-type semiconductor layer), as well as difficulty in preparing, with a solution-based deposition technique, a uniform layer of a p-type material on top of perovskite thin film (limited solubility in solvents which are orthogonal to perovskite). These drawbacks make it difficult to deposit a uniform and flat hole transport layer (p-type semiconductor) on the surface of perovskite. Lack of uniformity and flatness of the deposited p-type semiconductor layer may further negatively affect the character of the perovskite/carbon interface. Furthermore, the formation of voids/gaps at the HTL/carbon interface can occur, since the carbon electrode typically is comprised of graphite flakes that range in tens of nanometers up to micron size, and thereby the carbon surface features substantially high roughness. Thus, the carbon layer forms poor mechanical contact with planar HTL layer of nanometer roughness.

Some of the drawbacks associated with the insufficient charge-transport efficiency at the perovskite/carbon interface have been addressed in various patent publications.

Chinese patent application CN110752299 describes C-PSCs consisting of a transparent conductive oxide glass substrate, a hole blocking layer, a mesoporous electron transport layer, a perovskite light-absorbing layer, perovskite- interface link layer, and a carbon back electrode. The perovskite-interface link layer is made of cuprous thiocyanate or nickel oxide. In this architecture, the carbon back electrode is prepared only after the perovskite- interface link layer is formed. The carbon electrode layer is made from carbon paste which is applied onto the perovskite-interface link layer and subsequently dried.

Further, Chinese patent application CN104465994 describes the method for preparing perovskite solar cells with carbon top electrode (C-PSCs) having a hole transport layer (HTL) between the perovskite and carbon layer. The HTL layer is made of P3HT or Spiro-OMeTAD, and it is applied directly onto the formed perovskite layer, whilst the carbon layer is made from the carbon paste, applied on the surface of the prepared HTL layer. The paste is subsequently annealed at a substantially low-temperature range (70 to 150 degrees) for 1 - 2 minutes.

Another challenge in perovskite solar cell technology is the control of defects in the materials building up the photovoltaic devices, resulting in non-radiative recombination losses. The majority of recombination losses in perovskite solar cells take place at the interfaces with charge selective layers, an electron transporting layer (ETL) and a hole transporting layer (HTL), primarily due to higher density of the defects present at the surface of perovskite thin layers (films). Such defects derive from interruptions or imperfections in a crystal lattice of perovskite (i.e. semiconductor). These defects can induce electronic states within bandgaps, which in turn are responsible for trapping photogenerated charge carriers, increasing the rate of non-radiative recombination, and thereby reducing solar cell performance. In order to suppress these processes and also improve device stability, perovskite surfaces are subjected to passivation/modification processes. Due to the ionic character of perovskite material, known passivation strategies include ionic or coordinating interactions with external materials containing electron-rich (stabilization of positively charged defects, for example, undercoordinated Pb²⁺) or electron-deficient groups (negatively charged sites, such as Pb antisites, undercoordinated I⁻). Furthermore, molecular doping of the perovskite surface can be used to alter electronic properties and enhance the performance of devices based on the perovskite photo-active layer. This allows to tune the working functionality of the materials as well as to increase charge selectivity at the interface of perovskite and the other semiconductor, e.g. p-type semiconductor (reduced concentration of minority carriers).

As follows from the above publications, the architectures of perovskite solar cells provided with carbon top electrode (C-PSCs) undergo constant development aiming at optimization of the carbon/perovskite interface character, to facilitate charge transport and charge extraction efficiency, so as to improve C-PSCs devices overall performance.

### SUMMARY OF THE INVENTION

Therefore, it would be desirable to further develop the architecture of C-PSCs to improve the efficiency of charge transport between the perovskite and electrode layers to increase the efficiency in the C-PSCs.

In one aspect, the invention relates to a perovskite solar cell having a stack of layers, wherein the layers are arranged in the following order: a front electrode layer, a photo-active layer comprising a perovskite material, and a back electrode layer comprising a porous carbon material having a plurality of open-through pores, wherein the solar cell further comprises a charge transport material configured to transport the charges between the photo-active layer and the back electrode layer; the charge transport material fills at least some of the plurality of open-through pores of the porous carbon material of the back electrode layer and forms a bulk heterojunction with the perovskite material of the photo-active layer and an interface with the porous carbon material of the back electrode layer within the open-through pores.

The charge transport material disposed within the open-through pores of the back electrode layer and integrated with the perovskite bulk heterojunction, provides more efficient charge transport pathways, between the perovskite material and the carbon material, because this configuration allows for an increased area of the carbon/charge transport material interface, in comparison with the known flat (layered) arrangements of the charge transport materials. According to the present disclosure, the charge transport material by filling up the open-through pores of the porous carbon material, adjoins the entire area of walls of the open-through pores. Further, at the perovskite/carbon interface, the charge transport material fills voids, between the photo-active layer and the back contact layer, thereby providing an interfacial optimization of the solar cell. The porosity of the carbon material is due to that the carbon material is comprised of substantially large carbon particles (i.e. grains), preferably in a form of carbon flakes, preferably of carbon particle size from 2 to 9 µm. Thereby, the carbon particles cannot solely accommodate the roughness of the perovskite material, as well as they cannot fill the perovskite surface unevennesses to provide increased contact area. Thereby, the carbon particles of the carbon material cannot have intimate contact with the perovskite material of the photo-active layer (at the surface of the perovskite material). These inconveniences have been overcome by the present disclosure. Namely, according to the present disclosure, the charge transport material accommodates the roughness of the perovskite surface and fills the pores including open through pores 111 of the carbon material. This provides an increase in the solar cell efficiency, better electronic and mechanical contact as well as increased adhesion of the layers.

Preferably, the back electrode layer is configured to collect holes, and the charge transport material comprises a hole transport material (HTM) configured to draw and transport holes from the photo-active layer to the back electrode layer (11).

In this configuration, the BHJ involves the perovskite material as a donor of holes, and HTM as the hole acceptor, providing improved contact area between the perovskite material and the carbon material (filling the voids therebetween), improved hole extraction from the perovskite material, and reduced recombination at the interface. In this configuration, the carbon material acts as a metal that does not have an ideal hole selectivity (therefore, some minority carriers - electrons might be extracted, leading to increased recombination), and the incorporated HTM, according to the present disclosure, acts as the hole acceptor providing more efficient hole drawing from the perovskite.

Preferably, the hole transport material comprises at least one of the materials selected form the group consisting of: CuSCN, poly(3-hexylthiophene-2,5-diyl) (P3HT), Cu₂O, Cul, PTAA, and PEDOT:PSS.

The above materials are especially suitable for the developed configuration of the solar cell because each of the materials can work effectively as hole selective and hole transporting layer providing effective hole extraction from perovskite material and efficient hole transport through the layer, as well as high hole mobility.

Preferably, the hole transport material (HTL) is further admixed with at least one passivation compound. The passivation compound is preferably selected from the group consisting of alkylammonium salts, and fluorinated alkylammonium cations, materials containing electron-donating moieties (Lewis bases, electron donating atoms, such as O, N, and/or S) or materials containing electron-withdrawing moieties (e.g. Lewis acids).
The use of passivation compounds provides passivation of trap states present in the volume of the perovskite layer, as well as on the surface of the thin layer. Especially, alkylammonium salts provide filling uncoordinated Pb sites of the perovskite material, and formation of low-dimensional perovskite material; Lewis bases, the materials of electron-donating character, such as amines, amides, sulfides, carboxylic acids, phosphonic acids, e.g. pyridine, thiourea, thiophene, urea, aniline, benzylamine, thioacetamide, tribenzylphosphine oxide, acetic acid, 1-butanethiol, mercaptobenzoic acid, which provide filling uncoordinated Pb sites, and passivation of defects of positive charge; furthermore Lewis acids, the materials of electron-withdrawing character, e.g. fullerene, PCBM, iodopentafluorobenzene, trs(pentaflurophenyl)phospine, 2,3,5,6-tetrafluoro-7,7,8,8-tetracyanoquinodimethane (F4TCNQ) (with the mechanism of passivation of undercoordinated I, Pb-I antisites, which provide passivation of defects with a negative charge. The above-mentioned passivation process may be accomplished by synergistic defect passivation through the passivation compounds, i.e., Lewis Acid and Base, metal ions, or ionic bonds.

Preferably, wherein the front electrode layer is made of a material configured to collect electrons, selected from the group consisting of FTO, ITO, IZO and AZO.

This provides proper functionality of the cell structure.

Preferably, the stack of layers further comprises an electron transport layer (ETL) between the photo-active layer and the front electrode layer.
The presence of the electron transport layer (ETL) provides increased selectivity of the electrons and decreased charge recombination.

Preferably, the electron transport layer comprises a material selected from the group consisting of SnO₂, TiO₂, ZnO and PCBM.

The above materials serving as the electron transport layer provide increased selectivity of electrons and effective electron transport through the thickness of ETL towards the electrode material, thereby further reducing recombination losses.

Preferably, the porous carbon material of the back electrode layer has a value of specific surface area (SSA) in the range of 10 to 400 m²/g, measured by Brunauer-Emmet-Teller (N₂-BET) adsorption method.

This provides improved infiltration of the porous carbon material with the modification solution comprising the charge transfer material, and thus more regular distribution of the charge transfer material within the interface areas, i.e. between the carbon material of the back electrode layer. Furthermore, the carbon material, comprised in the back electrode layer 11 of the above-mentioned SSA value, provides improved control of the process of introducing the charge transfer material into the cell structure, leading to enhanced control of recrystallization in the perovskite material, thereby, preventing from a complete dissolution of the perovskite - so that BHJ is created therein.

Preferably, the back electrode layer is entirely made of the porous carbon material.

This provides an optimal area of the carbon/charge transport material interface between perovskite and carbon material, providing improved mechanical contact of the materials of the solar cell, and a greater area of BHJ formed.

Preferably, the porous carbon material comprises graphite flakes of particle size of 2 - 9 µm.

The graphite flakes not smaller than 2 µm allow easier penetration of the modification solution; however the graphite flakes larger than 9 µm might affect connectivity between the flakes and overall charge transport properties of the carbon electrode layer.

Preferably the photo-active layer is made of perovskite material selected from the group consisting of organic-inorganic perovskites of ABX₃ formula, wherein: A - is an alkylammonium cation, or metal cation such as Cs cation, B - is Pb, Sn, or mixture of Pb and Sn, and X - is halide anion selected from the group consisting of I-, Br- or CI-, or mixture thereof.

These perovskite materials provide more effective light harvesting, when implemented within the cell architecture with the back electrode comprising porous carbon material, leading to generation of free carriers, and providing effective career transport towards charge selective contacts, due to long carrier diffusion lengths.

In another aspect, the invention relates to a method for preparing a perovskite solar cell comprising providing a front electrode layer, forming a photo-active layer comprising a perovskite material, on the front electrode layer, forming a back electrode layer comprising a porous carbon material comprising a plurality of open-though pores, directly on the photo-active layer, filing the open-though pores of the porous carbon material with a modification solution comprising a charge transport material and a solvent system, and evaporating the solvent system from the modification solution.

The developed method provides efficient filling of the voids within the porous carbon material of the back contact electrode. Thus, a greater area of the interface: carbon/charge transport material, can be achieved. In the developed method, the charge transport material, in the form of a modification solution, is applied (poured) directly onto the already formed back electrode layer (from the top).The modification solution comprising the charge transport material can sink into the pores in carbon thereby reaching, thorough the open-though pores, the perovskite material of the photo-active layer. The solvent system of the modification solution partially dissolves the perovskite, at the boundaries of the perovskite grains (penetrating to some deepness the perovskite grains). Next, during the step of evaporation of the solvent system, the dissolved perovskite material re-crystalizes forming the bulk heterojunction (BHJ) with the charge transport material which remains in the pores and at the boundaries of the perovskite material, after the evaporation.

Moreover, re-crystallized perovskite forming BHJ provides higher optoelectronic quality due to more uniform perovskite grain sizes, more compact morphology and fewer defects in the re-crystalized perovskite material, which leads to limited non-radiative recombination.

Also, the developed method provides improved adhesion and mechanical contact of the adjacent materials, including perovskite, porous carbon, and charge transport material. The charge transport material that reaches the perovskite material through the open through pores, can fill the voids existing at the carbon/perovskite interface because the charge transport material is provided in the form of its liquid solution, i.e. the medication solution. It is further believed that the perovskite material recrystallizes inside the carbon pores. This way, the modification solution comprising the charge transport material can also reach some of the voids that have no direct connections with the open-through pores of the carbon material, and they are connected with the areas of the perovskite material, already reached by the modification solution. After filling the voids, the solvent system of modification solution evaporates, and the charge transport material remains trapped within the stack of the solar cell, which results in forming both the bulk heterojunction (BHJ) with the perovskite material of the photo-active layer and the interface with the porous carbon material of the back electrode layer within the open-through pores.

Preferably, the evaporation of the solvent system is carried out in a temperature of 18 to 200°C for and wherein the solvent system to be evaporated comprises at least one the component selected from the group consisting of DMF, DMSO, γ-butyrolactone (GBL), 2-methylpyrazine, 2-methoxyethanol, NMP, DMAC, acetonitrile, water, ethanol, isopropanol, toluene and chlorobenzene.

Use of such solvents as the components of the solvent system provides the required dissolution of the charge transport material and optional additives such as passivation compounds, if comprised in the modification solution, as well as partial dissolution of the perovskite material so that the pristine perovskite layer can be partially re-crystallized along with evaporation of the solvent system, at a relatively low-temperature range.

Preferably, filing the open-though pores is carried out using the modification solution comprising the charge transfer material selected form the group composing of CuSCN, PTTA, CuSCN, poly(3-hexylthiophene-2,5-diyl) (P3HT), Cu₂O, and Cul, PTAA, and PEDOT:PSS, wherein the total concentration of the charge transfer material in the modification solution ranges from 0,1 to 100 mg/ml.

Such composition provides desired parameters of the formed BHJ.

Preferably, filing the open-though pores is accomplished by a method selected from the group consisting of pouring, spray coating, inkjet printing, and slot-die coating of the modification solution on the porous carbon material of the back electrode layer.

Such methods provide efficient filling of the open-through pores.

### BRIEF DESCRIPTION OF DRAWINGS

Aspects and features of the present invention will become apparent by describing, in detail, exemplary embodiments of the present invention with reference to the attached drawings, in which:
Fig. 1 presents the prior art integrated perovskite/BHJ solar cell architecture of Xin Wu et all, "Efficient and stable carbon-based perovskite solar cells enabled by the inorganic interface of CuSCN and carbon nanotubes", J. Mater. Chem. A, 2019, 7, 12236-12243 (DOI: 10.1039/c9ta02014d);
Fig. 2A presents a perovskite solar cell structure before its treatment;
Fig. 2B presents a perovskite solar cell structure after its treatment, with a schematic depiction of BHJ (in enlargement);
Fig. 3A presents SEM image of a cross-section of a perovskite/BHJ solar cell, prepared by the method according to the present invention;
Fig. 3B presents SEM image of top-view of a perovskite-CuSCN mixed zone of a perovskite/BHJ solar cell, prepared by the method according to the present invention;
Fig. 4 present a SEM image of a cross-section of the perovskite/BHJ solar cell, where the perovskite material is infiltrated with CuSCN, with measured layers thisckesses, prepared by the method according to the present invention;
Fig 5A presents a cross-section SEM image of perovskite/carbon cell architecture, without modification - comparative example;
Fig. 5B presents a cross-section SEM image of perovskite/carbon cell architecture, wherein the perovskite material is infiltrated with CuSCN, according to the present disclosure;
Fig. 6 presents current density-voltage characteristics of perovskite solar cells without the modification (comparative) and after a modification treatment according to the present disclosure.

### DETAILED DESCRIPTION OF EMBODIMENTS

Reference will now be made to embodiments, examples of which are illustrated in the accompanying drawings. Aspects and features of the developed solar cell will be described with reference to the accompanying drawings. In the drawings, like reference numerals denote like elements. The present invention, however, may be embodied in various different forms and should not be construed as being limited only to the illustrated embodiments. Rather, the presented embodiment is provided as example so that this disclosure will be thorough and complete, and will fully convey the aspects and features of the present invention to those skilled in the art. It shall be understood that not all of the features shown in the embodiment are essential and the scope of the protection is defined not by means of literally shown embodiment, but by the features provided in the claims.

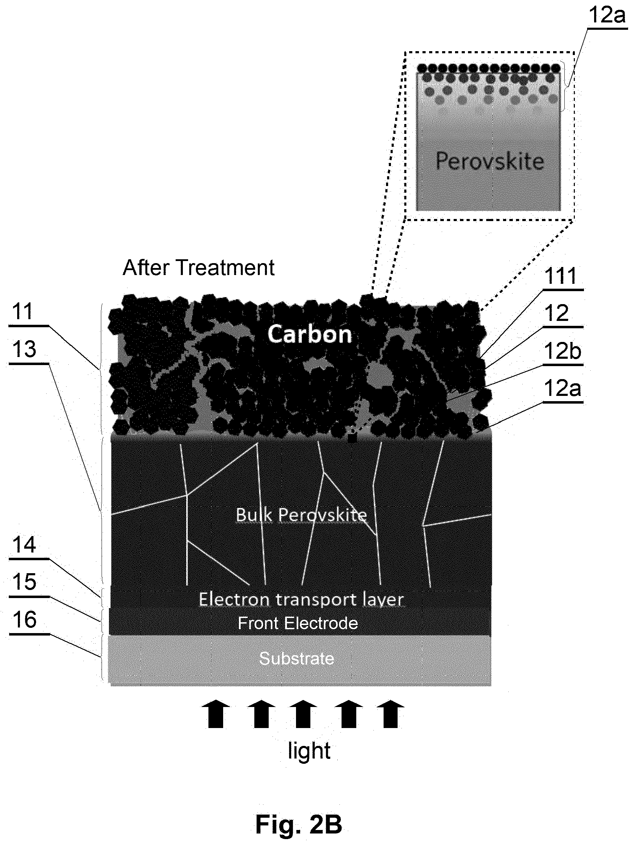

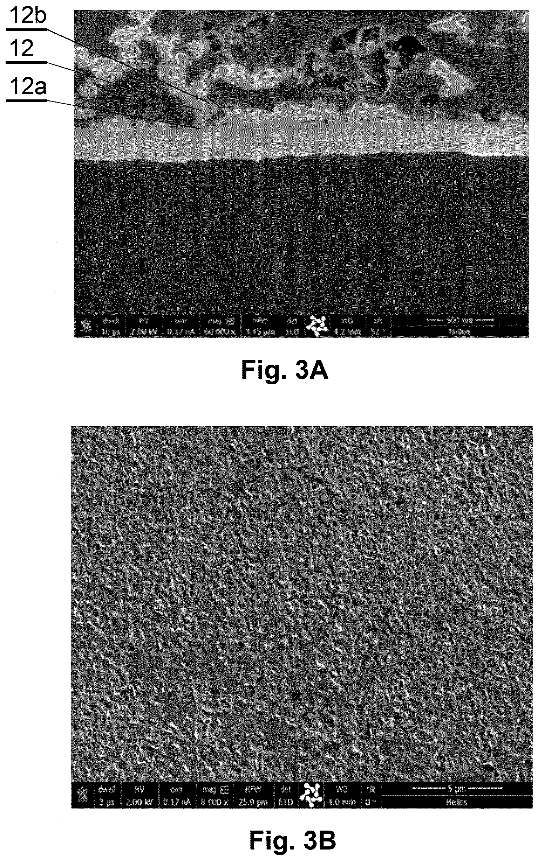

Figs. 2B, 3 present a perovskite solar cell according to the present invention. The solar cell comprises a photo-active layer 11 comprising perovskite material, preferably the light active layer can be entirely made of the perovskite material. The non-limiting examples of the perovskite materials for the photo-active layer are selected from the group consisting of 3D, 2D, and quasi-2D perovskite, for example: 3D perovskites of general formula: ABX₃ wherein A denotes methylammonium, formamidinium, caesium or mixture thereof, B denotes Pb, Sn or mixture thereof X denotes iodine, bromine, fluorine or mixture thereof; 2D perovskite of general formula A'₂BX₄ wherein A' denotes large alkylammonium cation (e.g. butylammonium, phenethylammonium or 4-fluorophenethylammonium, etc.), B denotes Pb, Sn or mixture thereof, X denotes iodine, bromine, fluorine or mixture thereof; or mixture of 2D and3D preovskites, called also quasi-2D perovskites of general formula A'₂Aₙ₋₁PbₙX₃ₙ₊₁, wherein A' denotes large alkylammonium cation such as e.g. butylammonium, phenethylammonium, or 4-fluorophenethylammonium, etc., A denotes methylammonium, formamidinium, caesium or mixture thereof, B denotes Pb, Sn or mixture thereof, X denotes iodine, bromine, fluorine or mixture thereof; in the above formulas n typically can equal 3-6.

Furthermore, the perovskite solar cell comprises a front electrode layer 15, which may be made of various transparent or translucent materials, suitable for charge collection, and more preferably for electrons collection, for example, transparent conductive electrode (TCO), made of ITO, IZO, FTO, and/or AZO. The front electrode layer 15 may be deposited on the substrate 16, for example, deformable substrate (e.g. flexible) such as transparent or translucent plastic foil, e.g. made of PET (poly(ethylene terephthalate)), PEN ((poly(ethylene 2,6-naphthalate)), ETFE (poly(ethene-co-tetrafluoroethene)), and/or PI (polyimide); or rigid substrate 16, for instance, made from glass. The presence of deformable substrate 16 can provide deformability of the solar cell.

Further, the solar cell comprises back electrode layer 11 comprising porous carbon material having a plurality of open-though pores. Preferably the back electrode layer 11 is entirely made of porous carbon material. The porous carbon material, beside the open-though pores, may further comprise saccafe pores and/or closed pores.

The expression *'open-though pores'* used herein refers to the pores communicating with the external surfaces, which are open at two ends; the open-though pores are also called through pores.

The expression *'closed pores'* used herein refers to the pores with no open end, wherein the expression 'saccafe pores' refers to the *pores* being open only at one end. The saccafe pores are called also blind pores or dead-end pores.

Preferably, the carbon material of the back electrode layer 11 has a value of specific surface area (SSA) in the range of 10 to 400 m²/g, measured by Brauner-Emmett-Teller (N₂-BET) adsorption method. SSA value of the above range provides proper filling of the carbon material open-through pores with a modification solution comprising the charge transport material 12 and thereby obtaining a bulk heterojunction (BHJ) 12a zone, between the perovskite and charge transport material 12, as described herein.

The term 'specific surface area' (SSA) used herein is understood as the total surface area of a solid material per unit of mass. SSA value is dependent on particle size of material, as well as the material structure and porosity. The SSA value can be measured by Brauner-Emmett-Teller (N₂-BET) adsorption method.

Preferably the back electrode layer 11 is entirely made of porous carbon material of SSA value in the range of 10 to 400 m²/g. The back electrode layer 11 preferably has a thickness in the range of 5 to 15 µm, and more preferably of 10 to 15 µm. The above-mentioned SSA value and the thickness of the back electrode layer 11 together provide an improved infiltration of the back electrode layer 11 with the modification solution comprising the charge transport material 12. Thereby, the charge transport material 12 (infiltrating the porous carbon material of the back electrode layer 11) can reach the photo-active layer 13 comprising the perovskite material to effect appropriate perovskite re-crystallization, resulting in formation of the bulk heterojunction (BHJ) 12a zone. This way, the porous carbon material of the back electrode layer 11 protects, to some extent, the perovskite material. Namely, introduction the charge transport material 12, through the porosities of the porous carbon of the back electrode layer 11, provides means to control the bulk heterojunction (BHJ) 12a formation. This is due to the developed composition of the modification solution which infiltrates the porous carbon, and this way the charge transport material 12 reaches the perovskite material. The solvent system of the modification solution comprises ingredients that are selected so as to dissolve the charge transport material (to provide its substantially homogenous concentration in the modification solution) as well as to affect the re-crystallization process of the perovskite material, at the boundaries of the perovskite grains, thus, at the interface of the photo-active layer 13. Such selected ingredients for the solvent system do not dissolve the whole perovskite material, simultaneously effecting an indirect transfer of the charge transfer material 12, through the porosities of the carbon material (infiltration). As a result, optimal amount of molecules of the charge transfer material 12 reach the perovskite material, leading to formation the BHJ 12a of improved parameters, which is schematically showing in Fig. 2B, in an enlargement square.

Preferably, the porous carbon material of the back electrode layer 11 can be made from carbon particles having the particle size of 0,1 µm to 100 µm and more preferably the particle size of 2 to 9 µm. The carbon particles may be in a form of various shapes, e.g., flakes, such as known graphite flakes of particle size of 2 - 9 µm, which provide bigger pore size and improved infiltration of the porous carbon material with the charge transport material. Furthermore, 2 - 9 µm in size, the graphite carbon particles (flakes) - as the main raw material for the formation of the porous carbon material of the back electrode layer 11, can provide lower square resistance of the electrode layer 11, which is beneficial for the perovskite solar cell characteristics. In the perovskite solar cell architecture, layers 11, 13, 15 are arranged in a stack in which the photo-active layer 13 is disposed between the front electrode layer 11 and the back electrode layer 15.

The solar cell comprises a charge transport material 12 for transporting the charges between the photo-active layer 13 and the back electrode layer 11. Preferably, the charge transport material 12 is a hole transport material, e.g., p-type material, or p-type semiconductor. The non-limiting examples of the hole transport material that can be used for the solar cell are selected from the group consisting of CuSCN, poly(3-hexylthiophene-2,5-diyl) (P3HT), Cu₂O and Cul, copper phthalocyanine (CuPc), P3HT, PTAA, PEDOT:PSS, spiro-OMeTAD, and poly-TPD. Optionally the charge transport material 12 may be admixed with various compounds, for example, passivation compounds - the additives for passivating the perovskite material, e.g. selected from the group consisting of: alkylammonium salts, and fluorinated alkylammonium cations, materials containing electron-donating moieties (Lewis bases, electron donating atoms, such as O, N, and/or S) or materials containing electron-withdrawing moieties (e.g. Lewis acids).

The charge transport material 12 fills at least part of the plurality of open-through pores of the porous carbon material and forms a bulk heterojunction 12a with the perovskite material as well as an interface 12b with the porous carbon material, on walls of the open-through pores. In other words, the charge transport material 12 is disposed, within the solar cell structures, forming charge transport patches (i.e. electrically continuous regions) configured to transport charges between the perovskite material of the photo-active layer 13 and the porous carbon material of the back electrode layer 11, throughout the BHJ 12a and the interfaces 12b.

The above architecture allows for reduction of carrier recombination at the perovskite/carbon interface, as well as improved perovskite layer quality, due to the controlled re-crystallization process of the perovskite material, at forming BHJ. These factors also result in the improved long-term stability of the developed perovskite solar cell.

Further, the solar cell may comprise electron transport layer 14, between the front electrode layer 15 and the photo-active layer 13, for further reduction of hole-electron recombination losses. Non-limiting examples of the materials for the electron transport layer 14 are selected from the group consisting of: SnO₂, TiO₂, ZnO, and PCBM or fullerenes different than PCBM capable for transport of electrons.

### Preparation method

The method for preparation of the perovskite solar cell according to the present disclosure comprises preparing the stack of layers for the solar cell that comprises the front electrode layer 15, the back electrode layer 11 comprising the porous carbon material, and the photo-active layer 13 comprising perovskite material, arranged therebetween. The photo-active layer 13 directly adjoins the back electrode layer 11 so that the open-through pores 111, via one of their open ends, reach the perovskite material of the photo-active layer 13. The other open ends of the open-through pores 111 of the carbon material are mainly exposed on the opposite surface of the back electrode layer 11, thereby, they are accessible from the outside. The back electrode layer 11 comprising the areas of porous carbon material of SSA in a range of 10 to 400 m²/g may be prepared by various conventional methods. For example, the back electrode layer 11 substantially entirely made of the porous carbon material may be prepared by applying a carbon paste onto the perovskite material of photo-active layer 13. The used carbon paste may be commercially available, such as e.g. carbon paste: DN-CP01^{®} (Dyenamo AB, Stockholm, Sweden)) which mainly comprises graphite flakes as carbon donating ingredients. Optionally, the carbon paste may be prepared by mixing carbon materials such as graphite flakes (0,9 g) (mesh size of 1200 mesh size) and carbon black (0,3 g) with PMMA (0,25 g) dissolved in 2 ml chlorobenzene solvent. The polymeric binder (PMMA) is used for connecting the carbon materials together. Next, the mechanically mixed solution is grinded to micron size particles (5 - 10 microns) using a ball milling machine. The milling process can be performed in three steps of 1 hour each.

The carbon paste may be for example doctor bladed or screen-printed on the photo-active layer 11 comprising perovskite material, in an ambient atmosphere. Subsequently, the carbon paste may be subjected to annealing at 80 - 120°C, preferably for 5 - 30 min. Such conditions enable one to obtain a proper parameters of the porous carbon material of the back electrode layer 11.

Next, the obtained stack of layers (11, 13, 15) is subjected to the treatment involving filling the open-through pores 111 of the carbon material with the modification solution comprising the solvent system and the charge transport material dissolved with said solvent system. The concentration of the charge transport material in the modification solution preferably ranges from 0,1 to 100 mg/ml, and more preferably from 0,5 to 20 mg/ml. The solvent system of the modification solution can constitute a single solvent compound or a mixture of two or more than two solvents, selected to dissolve the charge transport material 12 and to partially dissolve the perovskite material of the photo-active layer 13. The modification solution can further comprise another comoponenets, e.g. one or more of passivation compounds serving for passivation of the perovskite material. The concentration of the passivation compound(s) in the modification solution can range from 0.1 mg/ml to 20 mg/ml.

Below, Table 1 presents the exemplary embodiments of composition of the modification solutions regarding the perovskite materials of the photo-active layer 13:

**Table 1 - Exemplary embodiments of modification solutions with respect to the perovskite materials of the photo-active layer:**

| Perovskite of the light active layer | Modification solution |
|---|---|
| MAPbl3 | 1 mg/ml of CuSCN in a mixture of DMF/isopropanol (DMF:isopropanol mixed in v/v ratio of 1:1) |
| Cs0.04(MA0.17FA0.83)0.96Pb(I0.83Br0.17)3 | 1 mg/ml of CuSCN in a mixture of DMF/alcohol (DMF:alcohol mixed in v/v ratio of 1:1), 0.5 mg/ml of butylammonium bromide as a passivation additive |
| MA0.17FA0.83Pb(I0.83Br0.17)3 | 2 mg/ml of Cul in a mixture of DMSO/CBZ (DMSO:alcohol mixed in v/v ratio of 1:1 |

The modification solution may be applied with various non-contact deposition techniques, e.g., pouring, spray coating, or inkjet printing, slot-die coating, onto the top surface of the back electrode layer 11. Via the open through pores 111, the modification solution comprising the charge transport material 12 (e.g., hole transport material) reaches the perovskite material 13, partially dissolving the pristine perovskite grains and filling the open through pores 111 of the porous carbon. This operation may be performed in ambient air; no inert atmosphere is needed. Following the introduction of a desired volume of the modification solution, the solvent system is evaporated, by heating the stack of layers in 80 - 120°C for 1 - 10 minutes. In these conditions the re-crystallization of perovskite occurs, and the desired BJH-perovskite/charge transport material is obtained, wherein the thickness of the obtained BHJ 12a zone is triggered by: volume of the modification solution, applied, concentration of charge transfer material (e.g. HTM) in the modification solution, particular composition of the solvent system used, and temperature of the substrate during the application. Thereby, the modification solution that reaches the perovskite material induces the perovskite re-crystallization. The re-crystallization provides an improvement in the quality of the photo-active layer as well as removal of discontinuities and defects in a perovskite material structure.

Further, due to the solvent system evaporation, the charge transport material, as well as other non-volatile ingredients - if present in the modification solution, 'solidify' within the pores of the porous carbon material, filling thereof. The charge transport material that fills the pores of the porous carbon material increases the selectivity of the perovskite-carbon interface for hole extraction and reduces the recombination losses. This is because the charge transport material forms continuous charge patches of enhanced quality. The patches involve perovskite/charge transport material BHJ 12a and interfaces 12b of carbon/charge transport material, which are arranged along the walls of the open through pores 111 of the porous carbon material of the back electrode layer. Thus, these interfaces area can be greatly increased.

Depending on the needs and the desired device architecture (comprising a plurality of the solar cells in a certain arrangement), between the subsequent steps of layers preparation, pattering (e.g. laser patterning) steps may be carried out.

Obtained this way, the stack of layers may be subjected to another treatment, e.g. encapsulation.

The developed perovskite solar cell structure can be incorporated in various solar cell devices, such as flexible solar cell devices for harvesting solar energy, implemented in a variety of applications, including outdoor applications, indoor applications, glass-based modules, flexible substrate-based modules, etc.

### Example:

It was prepared a functional, flexible perovskite photovoltaic device consisting of the following architecture:
PET / transparent conductive electrode (IZO) / electron transport material (SnO₂) / perovskite (MAPbl₃) / porous carbon electrode subjected to post-treatment with the hole transport material (CuSCN).

Instead of the architecture with MAPbl₃, the solar cell with FAPbl₃ can be achieved in the analogous manner.

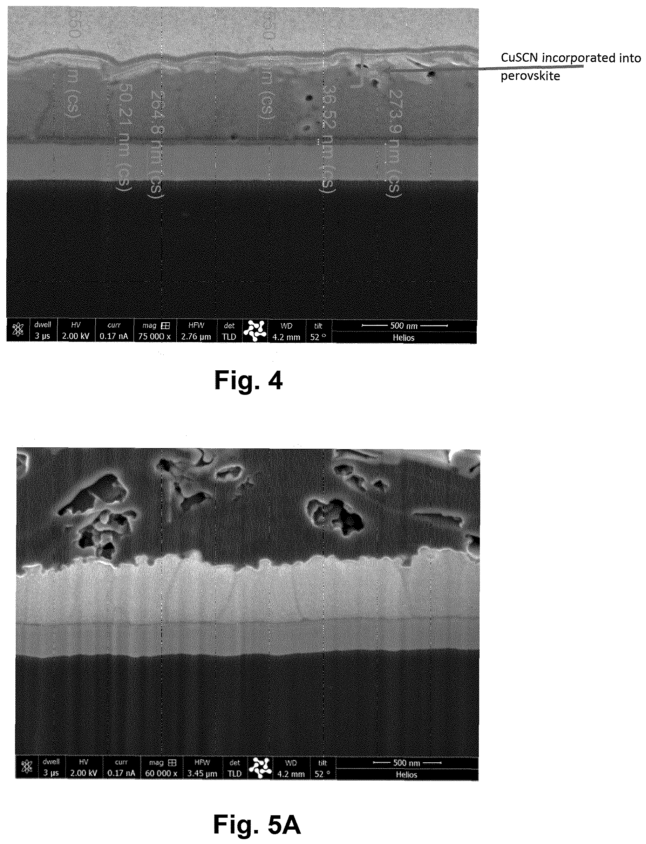

The modification solution comprising the charge transport material: CuSCN) (for hole transport) was prepared by dissolving CuSCN (1 mg) in 1 ml DMF:IPA (1:1 v/v). The solution was then coated on top of the porous carbon layer of the device via spray-coating. The device was kept for 5 minutes at 100°C during coating to ensure immediate evaporation of the solvent system and a fast re-crystallization of the perovskite material. The modification solution (CuSCN/DMF:IPA) was penetrating the porous carbon layer reaching the perovskite and partially dissolving pristine perovskite. Upon DMF/IPA evaporation, the partially dissolved perovskite has re-crystallized with the CuSCN. The final structure of the solar cell resulted in a non-dissolved (re-crystallized) perovskite layer, the bulk heterojunction layer formed out of re-crystallized perovskite/CuSCN (BHJ region), and the carbon-CuSCN regions (open through pores filled with CuSCN). The SEM image of the cross-section of obtained solar cell structure is shown in Fig. 3A (magnification - 70 000 x), and the top-view SEM image showing perovskite-CuSCN mixed zone (perovskite recrystallized and CuSCN incorporated, through carbon) is show in Fig. 3B (magnification -8000 x). Fig 4 shows SEM image of perovskite infiltrated (close to its top surface) with CuSCN, with measured thicknesses of the respective layers.

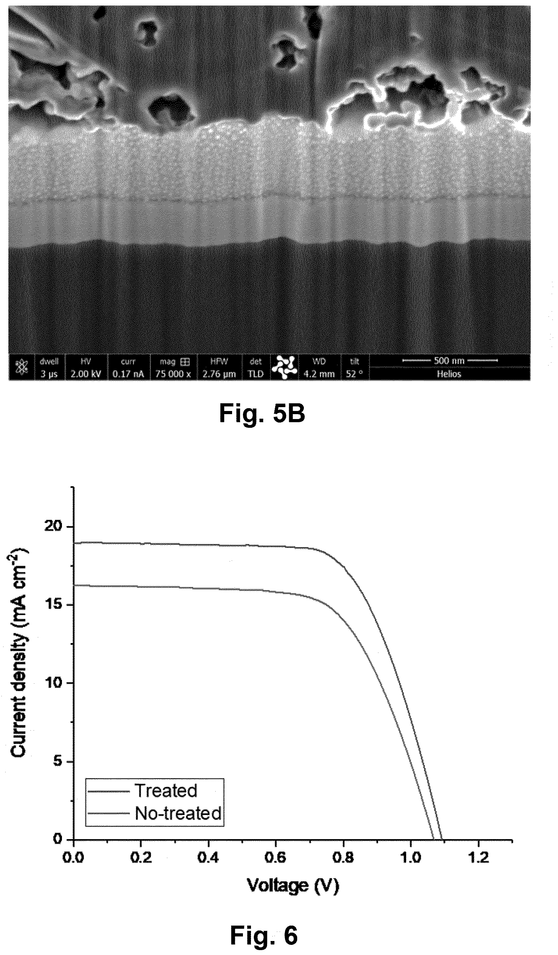

Fig. 5 represents another embodiment of the present disclosure, wherein Fig. 5A shows SEM image of the cell structure prior to the treatment with the CuSCN material, and Fig. 5B presents the SEM image of the cell structure after infiltration of the CuSCN material through the porous carbon material of the back electrode layer. In Fig. 5B BHJ zone (perovskite with CuSCN) is clearly visible, whilst in Fig. 5A no BHJ zone is visible.

Fig. 6 presents current density-voltage characteristics of perovskite solar cells without and after the modification treatment under AM 1.5 illumination and measurement. The devices without treatment performed with an efficiency of 10.5%. However, one can observe a major improvement in short-circuit current density (J_{sc}) and open circuit voltage (V_{oc}) for the devices after treating, according to the present disclosure, with the modification solution prepared with CuSCN in DMF:IPA. As a result it boosted the device efficiency to 13%. The obtained PCE improvement can be attributed to the recrystallisation of perovskite at the surface that eliminates any surface defects and better charge extraction through the CuSCN filled in the open-through pores.

## Claims

1. A perovskite solar cell having a stack of layers, wherein the layers are arranged in the following order: a front electrode layer (15), a photo-active layer (13) comprising a perovskite material, and a back electrode layer (11) comprising a porous carbon material having a plurality of open-through pores (111), wherein the solar cell further comprises a charge transport material (12) configured to transport the charges between the photo-active layer (13) and the back electrode layer (11),
**characterized in that**
the charge transport material (12) fills at least some of the plurality of open-through pores (111) of the porous carbon material of the back electrode layer (11) and forms a bulk heterojunction (12a) with the perovskite material of the photo-active layer (13) and an interface (12b) with the porous carbon material of the back electrode layer (11) within the open-through pores (111).

2. The solar cell according to claim 1 wherein the back electrode layer (11) is configured to collect holes, and the charge transport material (12) comprises a hole transport material (HTM) configured to draw and transport holes from the photo-active layer (13) to the back electrode layer (11).

3. The solar cell according to claim 2 wherein the hole transport material comprises at least one of the materials selected form the group consisting of: CuSCN, poly(3-hexylthiophene-2,5-diyl) (P3HT), Cu₂O, and Cul, PTAA, and PEDOT:PSS.

4. The solar cell according to claim 2 or 3 wherein the hole transport material is further admixed with at least one passivation compound.

5. The solar cell according any of the claims from 2 to 4 wherein the front electrode layer (15) is made of a material configured to collect electrons, selected form the group consisting of ITO, IZO, FTO, and/or AZO.

6. The solar cell according to claim 5 wherein the stack of layers further comprises an electron transport layer (14) between the photo-active layer (13) and the front electrode layer (15).

7. The solar cell according to claim 6 wherein the electron transport layer (14) comprises a material selected form the group consisting of SnO₂, TiO₂, ZnO and PCBM.

8. The solar cell according to any of the proceeding claims wherein the porous carbon material of the back electrode layer (11) has a specific surface area (SSA) value in the range of 10 to 400 m²/g, measured by Brunauer-Emmet-Teller (N₂-BET) adsorption method.

9. The solar cell according to any of the preceding claims wherein the back electrode layer (11) is entirely made of the porous carbon material.

10. The solar cell according to any of the preceding claims wherein the porous carbon material comprises graphite flakes of particle size of 2 - 9 µm.

11. The solar cell according to any of the preceding claims wherein the photo-active layer (13) is substantially entirely made of a perovskite material selected form the group consisting of perovskites of ABX₃ formula,
wherein:
A - is an alkylammonium cation, or metal cation such as Cs cation,
B - is Pb, Sn, or mixture of Pb and Sn, and
X - is halide anion selected from the group consisting of I⁻, Br or Cl⁻, or mixture thereof.

12. A method for preparing a perovskite solar cell according to any of the preceding claims, comprising:
- providing a front electrode layer (15),
- forming a photo-active layer (13) comprising a perovskite material, on the front electrode layer (15),
- forming a back electrode layer (11) comprising a porous carbon material comprising a plurality of open-though pores (111), directly on the photo-active layer (13),
- filing the open-though pores (111) of in the porous carbon material with a modification solution comprising a charge transport material (12) and a solvent system, and
- evaporating the solvent system from the modification solution.

13. The method according to claim 12 wherein the evaporation of the solvent system is carried out in a temperature range of 18 to 200OC, and wherein the solvent system to be evaporated comprises at least one component selected form the group consisting of DMF, DMSO, γ-butyrolactone (GBL), 2-methylpyrazine, 2-methoxyethanol, NMP, DMAC, acetonitrile, water, ethanol, isopropanol, toluene and chlorobenzene.

14. The method according to claim 12 or 13 wherein filing the open-though pores is carried out using the modification solution comprising the charge transfer material selected form the group composing of CuSCN, PTTA, CuSCN, poly(3-hexylthiophene-2,5-diyl) (P3HT), Cu₂O, and Cul, PTAA, and PEDOT:PSS, wherein the total concentration of the charge transfer material in the modification solution ranges from 0,1 to 100 mg/ml.

15. The method according to any of claims from 12 to 14 wherein filing the open-though pores is accomplished by a method selected from the group consisting of pouring, spray coating, inkjet printing, and slot-die coating of the modification solution on the porous carbon material of the back electrode layer.
